Europäisches Patentamt

European Patent Office

Office européen des brevets

(11) Veröffentlichungsnummer: **0 222 739**
**A2**

(12) # EUROPÄISCHE PATENTANMELDUNG

(21) Anmeldenummer: **86890317.0**

(22) Anmeldetag: **13.11.86**

(51) Int. Cl.⁴: **G 03 F 1/00**

(30) Priorität: **13.11.85 AT 3313/85**

(43) Veröffentlichungstag der Anmeldung:
**20.05.87 Patentblatt 87/21**

(84) Benannte Vertragsstaaten:
**AT BE DE FR GB IT NL SE**

(71) Anmelder: **IMS Ionen Mikrofabrikations Systeme
Gesellschaft m.b.H.
Schreygasse 3
A-1020 Wien(AT)**

(72) Erfinder: **Löschner, Hans, Dr.
Vegagasse 6/2
A-1190 Wien(AT)**

(72) Erfinder: **Stengl, Gerhard, Dr.
Hammergasse 11
A-9500 Villach Kärnten(AT)**

(72) Erfinder: **Wolf, Peter, Dr.
Corneliusgasse 3
A-1060 Wien(AT)**

(74) Vertreter: **Krause, Ernst, Dipl.-Ing. et al,
Dipl.- Ing. Krause, Ernst Dipl. Ing. Casati, Wilhelm
Patentanwälte Amerlingstrasse 8
A-1061 Wien(AT)**

(54) **Verfahren zur Herstellung einer Transmissionsmaske.**

(57) Die Erfindung betrifft ein Verfahren zur Herstellung einer Transmissionsmaske, die eine Maskenfolie und einen Rahmen für diese aufweist, wobei die Maskenfolie bevorzugt aus Nickel oder Invar stressfrei mit dem Rahmen, bevorzugt aus Silizium, verankert ist.

FIG.6

EP 0 222 739 A2

Die Erfindung betrifft ein Verfahren zur Herstellung einer Transmissionsmaske für elektromagnetische oder Teilchenstrahlung, wobei die Transmissionsmaske einen Halterahmen für eine Maskenfolie aufweist, die für die elektromagnetische oder für die Teilchenstrahlung durchlässige Gebiete aufweist. Beim Einsatz solcher Masken werden die Strukturen der Maskenfolie, d.h. die Struktur der durchlässigen Gebiete (Öffnungen) auf Substrate, insbes. Halbleitersubstrate, übertragen.

Derartige Masken werden in der Halbleiterindustrie für Elektronen-, Ionen- und Röntgenlithographie eingesetzt. Da die Maskenfolien bei einer Fläche von mehreren Quadratzentimetern und darüber eine Dicke im Bereich von bloß 0,001 mm aufweisen, bedürfen sie sowohl zu Transport bei Herstellung und Verwendung, als auch zur Gewährleistung einer ebenen Maskenfläche einer Halterung, die zweckmäßigerweise ringförmig oder rahmenförmig die Maskenfolie umschließt.

Im Betrieb bewirkt die auf die Transmissionsmaskenfolie einfallende elektromagnetische oder Teilchenstrahlung eine Erwärmung der Maskenfolie. Um die dadurch bewirkte Ausdehnung der Maskenfolie möglichst gering zu halten, kann man entweder die auf die Maske einfallende Energiedichte beschränken, so daß Formänderungen der Maskenstruktur vernachlässigbar werden oder die Maskenfolie wird so hergestellt, daß sie vorgespannt ist, d.h. vor Auftreten von Betriebsbelastungen bereits unter Zugspannung steht. Diese Vorspannung kann entweder bereits beim Herstellen der Maskenfolie, z.B. durch Abscheiden von Bornitrid aus der Gasphase oder von Siliziumnitrid/Siliziumoxid-Mehrfachschichten durch die Wahl geeigneter Herstellungsparameter in der Folie erzeugt werden – oder nach deren Herstellung durch Einspannen der zunächst spannungsfrei auf einem Substrat hergestellten Maskenfolie, in einem massiven Spannrahmen erzielt werden. Das letztgenannte Verfahren ist in der AT-PS 371 947 als Methode der thermischen Vorspannung beschrieben. Die Maskenfolie (z.B. aus Nickel) wird dabei bei Temperaturen unterhalb der Raumtemperatur in einen Rahmen eingespannt, dessen thermischer Ausdehnungskoeffizient größer als der der Folie ist. Durch Temperatursteigerung, ausgehend von der Einspanntemperatur, spannt der Rahmen die Folie. Im Betrieb darf die Folie unter Einwirkung des Abbildungsmediums nur so stark erwärmt werden, daß die Vorspannung der Folie nicht verloren geht. Nun ist aber eine Beschränkung der Arbeitstemperatur einer Maske auf wesentlich weniger als 100°C aus zwei Gründen nicht vorteilhaft: Zunächst benötigt eine echte Produktionstechnologie zur Gewährleistung eines hohen Durchsatzes (bearbeitete Substrate pro Zeiteinheit) möglichst hohe Leistungsdichten am Substrat, daher auch auf der Maske. Derart hohe Leistungsdichten liefern insbesondere Ionenlithographiegeräte, mit welchen nicht nur organische Fotolacke, sondern auch anorganische Schichten strukturiert werden können. Weiters ist bei Prozessen, bei denen die Maske im Vakuum verwendet wird, eine Maskentemperatur von größer als 100°C von Vorteil, da sich bei dieser Temperatur ein dynamisches Gleichgewicht zwischen Anlagern und Absputtern von auf die Maske einfallenden Teilchen (Kontaminationsschichte etc.) einstellt. Die nach dem vorstehend beschriebenen Verfahren der thermischen Vorspannung montierten Masken mit einer Folienmaske aus Metall im allgemeinen nur für Testzwecke geeignet, da durch das Vorspannen nicht tolerierbare Verzerrungen der Maskenstruktur auftreten.

Gegenstand der vorliegenden Erfindung ist nun ein Herstellungsverfahren für Transmissionsmasken, nach welchem ebene, weitgehend spannungsfreie Metall-Maskenfolien realisiert werden. Dazu wird bei einem Verfahren der eingangs erwähnten Art vorgeschlagen, daß gemäß der Erfindung ein Siliziumwafer auf zumindest einer seiner Oberflächen mit einer ring- oder rahmenförmigen Abdeckung versehen wird, die bevorzugt aus Materialien besteht, z.B. Schichten aus Siliziumdioxid und Siliziumnitrid, die gegen ein Ätzmittel widerstandsfähiger sind als es Silizium gegen dieses Ätzmittel ist, daß die der mit der ring- oder rahmenförmigen Abdeckung versehenen Oberfläche gegenüberliegende Oberfläche mit einer Haftvermittlerschicht, bevorzugt aus Chrom und Kupfer, versehen wird, daß auf dieser Schicht die strukturierte Maskenfolie, aufgebaut und streßfrei strukturiert wird, wobei der Aufbau durch galvanische Methoden, durch Aufdampfen oder Sputtern, bevorzugt von INVAR, erfolgen kann und die Strukturierung der metallischen Maskenfolie durch eine Resistmaskierung und im Falle des Aufdampfens oder Sputterns durch einen Abhebeprozeß (lift-off) oder durch Ätzen bevorzugt durch anisotrope reaktive Ionenätzverfahren, erfolgt und daß das Material des Wafers in dem von der ring- oder rahmenförmigen Abdeckung umschlossenen Innenbereich zumindest bis auf die Schicht der Maskenfolie bzw. die Schicht, auf der die Maskenfolie aufgebaut ist, selektiv durch Ätzen entfernt wird und die nunmehr freiliegende Haftvermittlerschicht durch selektives Ätzen ebenfalls entfernt wird. Das Material des Wafers und jenes der Maskenfolie sollen günstigerweise im verwendeten Temperaturbereich (Herstellungstemperatur Raumtemperatur bis Betriebstemperatur größer als 100° einen möglichst gleichen thermischen Ausdehnungskoeffizienten besitzen. Durch Anwendung des erfindungsgemäßen Verfahrens gelingt es, die Maskenfolie stressfrei oder nahezu stressfrei mit dem Substrat, auf dem sie erzeugt wurde, zu verbinden. Die Maskenfolie, die - wie bereits erwähnt - äußerst dünn ist, ist durch Anwendung des erfindungsgemäßen Verfahrens am Rahmen verankert, der wesentlich kräftiger als die Maskenfolie ist, so daß die Maskenfolie gehandhabt werden kann, ohne während der Handhabung beschädigt zu werden.

In weiterer Ausgestaltung des erfindungsgemäßen Verfahrens kann vorgesehen werden, daß zur Bildung der ringförmigen oder rahmenförmigen Abdeckung der Siliziumwafer, bevorzugt in einem Abscheideverfahren aus der Gasphase, mit einer Siliziumnitridschicht, bevorzugt bis zu einer Dicke von 500 nm oder mit einer Doppelschicht aus Siliziumdioxid, bevorzugt bis zu einer Stärke von 200 nm, und Siliziumnitrid, bevorzugt bis zu einer Stärke von 50 nm, allseitig bedeckt wird, und daß zumindest auf einer Fläche des Wafers, bevorzugt jedoch auf zwei einander gegenüberliegenden Flächen des Wafers, die Siliziumnitridschicht bzw. die Doppelschicht, unter Belassung des Ringes oder Rahmens, entfernt wird, z.B. durch Plasmaätzen oder Ätzen mittels Flußsäure.Die Bildung der Abdeckung für das Abtragen des Si-Wafers unter dem Arbeitsbereich der Maskenfolie läßt sich auf diese Weise besonders einfach ausführen und sichert den Halt der Abdeckung am Wafer.

Zur Bildung der Maskenfolie in einem galvanischen Aufbauprozeß kann vorgesehen werden, daß auf die Haftvermittlerschicht eine elektrisch isolierende Schicht aufgebracht und strukturiert wird, z.B. durch Belichtung mit UV-Licht bei einer Schicht aus einem Photolack, derart, daß die für die Teilchenstrahlung oder die elektromagnetische Strahlung durchlässigen Gebiete von der Isolationsschicht abgedeckt werden, daß hierauf durch galvanisches Aufwachsen auf die von der Isolierschicht freien Bereiche eine metallische Folie abgeschieden wird, worauf die Isolierschicht entfernt wird, z.B. durch Lösen, bevorzugt in Aceton. Die Maskenfolie kann jedoch auch dadurch hergestellt werden, daß auf die Haftvermittlerschicht ein Resist aufgebracht und strukturiert wird, derart, daß an der der Haftvermittlerschicht gegenüberliegenden Oberfläche der Resist verbreitert ist, also dort eine Art Dach besitzt. Dann kann Metall aufgedampft oder gesputtert werden, wofür sich auch INVAR eignet. Die Ränder der aufgedampften oder aufgesputterten Metallfolie liegen dabei im Abstand von den Rändern des Resists, da die dachartige Verbreiterung an der Oberfläche des Resists beim Aufdampfen oder Sputtern verhindert, daß das aufgedampfte oder gesputterte Material die Ränder des Resists erreicht. Der Resist kann daher nach dem Aufdampfen oder Sputtern der Metallfolie in einem Abhebeprozeß (lift-off) entfernt werden. Bei diesem Verfahren verlaufen die Kanten der Metallfolie in der Regel nicht senkrecht zur Haftvermittlerschicht. Sollen die die Öffnungen in der Folie begrenzenden Kanten senkrecht zur Haftvermittlerschicht verlaufen, so kann dies durch Anwenden einer anisotropen Methode (z.B. mit einem Dreilagen- Resistsystem) erreicht werden, wobei kein Unterätzen des Resists auftritt. Bei Anwendung des Dreilagen-Resistsystems wird zunächst auf die Haftvermittlerschicht eine Grundschicht aufgetragen, auf diese dann eine Zwischenschicht aus SiO aufgedampft und die oberste Schicht von einem elektronen- oder photoempfindlichen dünnen Resist gebildet. Die oberste Schicht wird dann durch Elektronen- oder Photolithographie strukturiert und die Struktur in die SiO-Zwischenschicht, z.B. im $CHF_3$-Plasma, übertragen. Die Übertragung in die Grundschicht erfolgt dann im $O_2$-Plasma, wobei die strukturierte Zwischenschicht als Maskierung dient.

Die Maskenfolie kann auf dem Siliziumwafer jedoch auch durch Aufdampfen oder Sputtern des Folienmaterials auf die Haftvermittlerschicht hergestellt werden, wobei INVAR bevorzugt wird, da es im Arbeitsbereich einen mit Silizium ungefähr gleichen thermischen Ausdehnungskoeffizienten besitzt. Die Strukturen können bevorzugt durch ein anisotropes reaktives Ätzverfahren in das Folienmaterial übertragen werden, nachdem auf der homogenen Metallschicht ein Resist bzw. eine geeignete Maskierungsschicht aufgebaut und strukturiert wurde.

Das erfindungsgemäße Verfahren wird nachstehend anhand eines Ausführungsbeispiels näher erläutert. Die

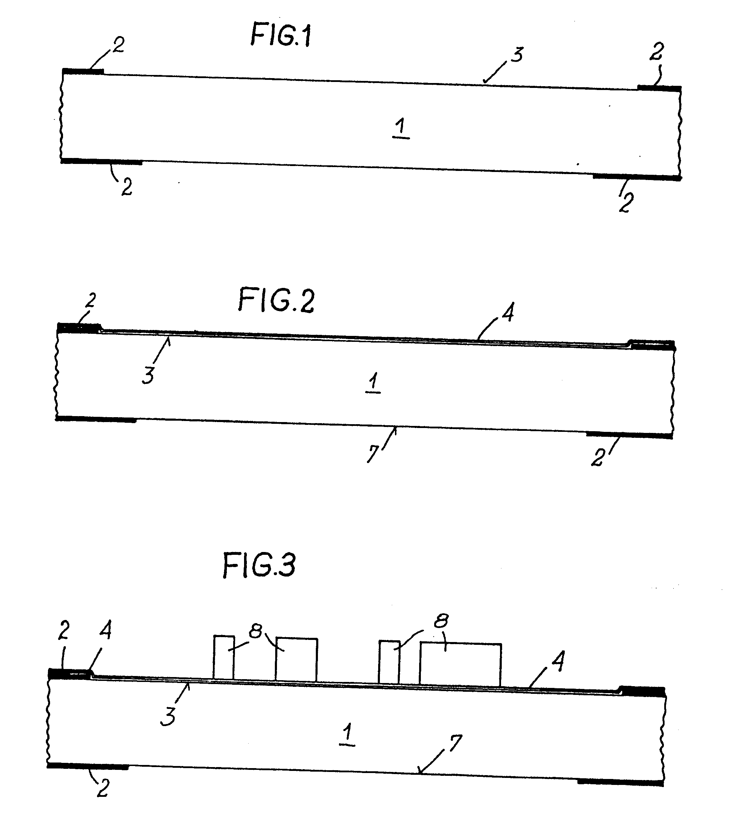

Figuren 1 bis 6 zeigen dabei unterschiedliche Stadien in der Herstellung der Transmissionsmaske, jeweils in einem Längsschnitt.

Ein Siliziumwafer 1 wird bei der Herstellung als Substrat und später auch als Rahmen für die Maskenfolie 5 verwendet. Siliziumwafer zeichnen sich durch besonders hohe Oberflächenqualität und konstante Ätzeigenschaften bei günstigen Anschaffungsbedingungen aus. Der Siliziumwafer 1 wird in einem Abscheideverfahren aus der Gasphase allseitig mit einer Abdeckung versehen, die als etwa 500 nm dicke Siliziumnitridschicht ausgebildet werden kann. Es ist auch möglich, nur auf einer Oberfläche eine Abdeckung vorzusehen. Die Abdeckung kann auch aus mehreren Schichten aufgebaut werden. Insbesondere eine zweischichtige Ausführung ist zweckmäßig. Davon kann eine Schicht aus $SiO_2$ bestehen und 200 nm dick sein, während die zweite Schicht in einer Stärke von 50 nm aus Siliziumnitrid hergestellt werden kann. Die Abdeckung wird dann ring- oder rahmenartig gestaltet, dadurch, daß mittels einer Ätzlösung (z.B. Flußsäure) oder durch Plasmaätzen die Abdeckung im Mittenbereich des Wafers 1 entfernt wird, sodaß nur mehr eine seitliche Abdeckung 2 in Form eines Rahmens oder eines Ringes auf zwei einander gegenüberliegenden Flächen 3, 7 des Wafers 1 verbleibt (Fig. 1). Es ist jedoch auch möglich, die Abdeckung auf der oberen Oberfläche 3 des Wafers 1 total zu entfernen. Die Abmessung der seitlichen Abdeckung 2 wird im Hinblick auf die Größe der herzustellenden Maskenfolie 1 bestimmt.

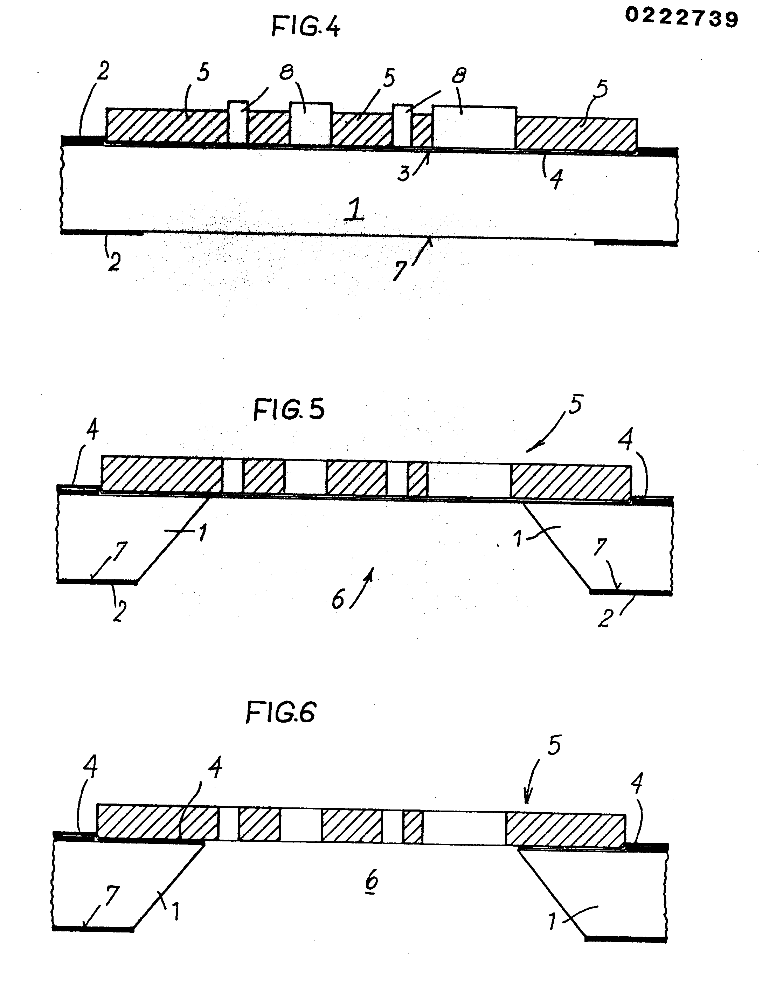

Auf die obere Oberfläche 3 des Wafers 1 wird eine Schicht 4 aufgebracht, auf der die Maskenfolie gebildet wird. Die Schicht 4 wird als Haftvermittlerschicht ausgebildet und besteht bevorzugt aus einer Chrom- und einer Kupferschicht (Fig. 2). Auf die Schicht 4 kann wird ein Photolack 8 aufgetragen und strukturiert. Bevorzugt erfolgt das Auftragen einer Dreilagenresistschicht, sodaß nach dem Strukturieren der obersten Schicht die Strukturübertragung in die dicke organische Grundschicht durch einen anisotropen Ätzprozess erfolgen kann und dabei senkrechte Kanten (Fig. 3) entstehen. Auf den nicht abgedeckten Teil des Substrats wird durch galvanische Abscheidung die Maskenfolie 5 als metallischer Film gewonnen (Fig. 4). Durch Zugabe diverser Badzusätze kann die Abscheidung z.B. von Nickel derart gesteuert werden, daß die galvanisch aufgewachsene Folie 5 frei von inneren Spannungen und von ausreichender Oberflächenqualität ist.

Nach dem Aufbau der die Maskenfolie 5 bildenden Schicht wird im Bereich der Maskenfolie 5, der Siliziumwafer 1 bis auf den Ring bzw. Rahmen (Abdeckung 2) durch selektives Ätzen, z.B. mittels Kalilauge entfernt (Fig. 5). Sodann kann die Schicht 4 (Haftvermittlerschicht) im Inneren des vom Si-Wafer 1 umspannten Bereiches selektiv entfernt werden. Auf diese Weise wird eine spannungsfreie Maskenfolie 5 in einem Haltering erzeugt (Fig. 6).

Patentansprüche:

1. Verfahren zur Herstellung einer Transmissionsmaske für elektromagnetische oder Teilchenstrahlung, wobei die Transmissionsmaske einen Halterahmen für eine Maskenfolie aufweist, die für die elektromagnetische oder für die Teilchenstrahlung durchlässige Gebiete aufweist, dadurch gekennzeichnet, daß ein Siliziumwafer auf zumindest einer seiner Oberflächen mit einer ring- oder rahmenförmigen Abdeckung versehen wird, die bevorzugt aus Materialien besteht, z.B. Schichten aus Siliziumdioxid und Siliziumnitrid, die gegen ein Ätzmittel widerstandsfähiger sind als es Silizium gegen dieses Ätzmittel ist, daß die der mit der ring- oder rahmenförmigen Abdeckung versehenen Oberfläche gegenüberliegende Oberfläche mit einer Haftvermittlerschicht, bevorzugt aus Chrom und Kupfer, versehen wird, daß auf dieser Schicht die metallische Maskenfolie aufgebaut und streßfrei strukturiert wird, wobei der Aufbau durch galvanische Methoden, durch Aufdampfen oder Sputtern, bevorzugt von INVAR, erfolgen kann und die Strukturierung der metallischen Maskenfolie durch eine Resistmaskierung und im Falle des Aufdampfens oder Sputterns durch einen Abhebeprozeß (lift-off) oder durch Ätzen, bevorzugt durch anisotrope reaktive Ionenätzverfahren, erfolgt und daß das Material des Wafers in dem von der ring- oder rahmenförmigen Abdeckung umschlossenen Innenbereich zumindest bis auf die Schicht der Maskenfolie, bzw. die Schicht, auf der die Maskenfolie aufgebaut ist, durch Ätzen entfernt wird und die nunmehr freiliegende Haftvermittlerschicht durch selektives Ätzen ebenfalls entfernt wird.

2. Verfahren nach Anspruch 1, dadurch gekennzeichnet, daß zur Bildung der ringförmigen oder rahmenförmigen Abdeckung der Siliziumwafer, bevorzugt in einem Abscheideverfahren aus der Gasphase, mit einer Siliziumnitridschicht, bevorzugt bis zu einer Dicke von 500 nm oder mit einer Doppelschicht aus Siliziumdioxid, bevorzugt bis zu einer Stärke von 200 nm, und Siliziumnitrid, bevorzugt bis zu einer Stärke von 50 nm, allseitig bedeckt wird, und daß zumindest auf einer Fläche des Wafers, bevorzugt jedoch auf zwei einander gegenüberliegenden Flächen des Wafers, die Siliziumnitridschicht bzw. die Doppelschicht, unter Belassung des Ringes oder Rahmens, entfernt wird, z.B. durch Plasmaätzen oder Ätzen mittels Flußsäure.

3. Verfahren nach Anspruch 1 oder 2, dadurch gekennzeichnet, daß auf die Haftvermittlerschicht eine elektrisch isolierende Schicht aufgebracht und strukturiert wird, z.B. durch Belichtung mit UV- Licht, bei einer Schicht aus einem Photolack, derart, daß die für die Teilchenstrahlung oder die elektromagnetische Strahlung durchlässigen Gebiete von der Isolationsschicht abgedeckt werden, daß hierauf die galvanische Abscheidung der Metallfolie auf die von der Isolierschicht freien Bereiche erfolgt, worauf die Isolierschicht entfernt wird, z.B. durch Lösen, bevorzugt in Aceton.

4. Verfahren nach Anspruch 1 oder 2, dadurch gekennzeichnet, daß auf die Haftvermittlerschicht ein Resist aufgetragen und strukturiert wird, derart, daß an der der Haftvermittlerschicht gegenüberliegenden Oberfläche der Resiststruktur Verbreiterungen gebildet werden, daß Metall durch Aufdampfen oder Sputtern in die Öffnungen der Resiststruktur eingebracht werden unter Freihalten eines seitlichen Abstandes zu den Wandungen der Resiststruktur, daß hernach der Resist in einem Abhebeprozeß (lift-off) entfernt wird.

5. Verfahren nach Anspruch 1 oder 2, dadurch gekennzeichnet, daß auf die Haftvermittlerschicht in drei aufeinanderfolgenden Schritten je eine Resistschicht aufgetragen wird, wobei auf die erste Resistschicht (Grundschicht) eine demgegenüber wesentlich dünnere Schicht (Zwischenschicht) bevorzugt aus SiO aufgedampft und auf diese Zwischenschicht eine weitere, ebenfalls dünne elektronen- oder photoempfindliche Schicht aufgetragen wird, daß die oberste Schicht durch Elektronen- oder Photolithographie strukturiert und die Struktur in die Zwischenschicht, z.B. im $CHF_3$-Plasma übertragen wird, worauf mit der nunmehr strukturierten Zwischenschicht als Maskierung, die Struktur in die Grundschicht bevorzugt im $O_2$-Plasma übertragen wird, worauf durch Aufdampfen oder Sputtern die Metallfolie in den Öffnungen des Resists gebildet wird und der Resist hernach abgetragen wird.

6. Verfahren nach Anspruch 1 oder 2, dadurch gekennzeichnet, daß auf die Haftvermittlerschicht durch Aufdampfen oder Sputtern bevorzugt von INVAR die Metallfolie gebildet wird, daß auf die Metallschicht ein Resist bzw. eine Maskierungsssschicht aufgebaut und strukturiert wird, worauf durch einen anisotropen, reaktiven Ätzvorgang die Struktur in die Metallfolie übertragen wird.

FIG.1

FIG.2

FIG.3

FIG.4

FIG.5

FIG.6